Europäisches Patentamt

European Patent Office

Office européen des brevets

(19)

(11) **EP 0 735 160 B1**

(12) **FASCICULE DE BREVET EUROPEEN**

(45) Date de publication et mention
de la délivrance du brevet:
**30.08.2000 Bulletin 2000/35**

(51) Int Cl.[7]: **C23C 16/40**, C23C 16/44,
C23C 16/50, G02B 6/12

(21) Numéro de dépôt: **96400691.0**

(22) Date de dépôt: **29.03.1996**

(54) **Procédé et appareil de dépôt chimique en phase vapeur, à basse température, assisté par plasma micro-ondes, de couches minces de silice**

Verfahren und Vorrichtung zur mikrowellenunterstützten CVD von Siliciumoxidschichten bei niedriger Temperatur

Process and apparatus for microwave assisted low temperature CVD of silica layers

(84) Etats contractants désignés:
**DE FR GB**

(30) Priorité: **31.03.1995 FR 9503809**

(43) Date de publication de la demande:
**02.10.1996 Bulletin 1996/40**

(73) Titulaire: **FRANCE TELECOM
75015 Paris (FR)**

(72) Inventeurs:
• **Moisan, Monique
22300 Lannion (FR)**
• **Pavy, Dominique
22300 Lannion (FR)**
• **Moisan, Hervé
22300 Lannion (FR)**

(74) Mandataire: **Texier, Christian et al
Cabinet Regimbeau,
26, Avenue Kléber
75116 Paris (FR)**

(56) Documents cités:
**EP-A- 0 289 402**

• **IEICE TRANSACTIONS ON ELECTRONICS, SEPT. 1992, JAPAN, vol. E75-C, no. 9, ISSN 0916-8524, XP000322425 FUYUKI T ET AL: "Deposition of high-quality silicon dioxide by remote plasma CVD technique"**
• **PATENT ABSTRACTS OF JAPAN vol. 012, no. 166 (P-704), 19 Mai 1988 & JP-A-62 279303 (SUMITOMO ELECTRIC IND LTD), 4 Décembre 1987,**
• **IEE PROCEEDINGS J (OPTOELECTRONICS), AUG. 1986, UK, vol. 133, no. 4, ISSN 0267-3932, pages 264-266, XP000570914 NOURSHARGH N ET AL: "Plasma deposition of GeO/sub 2//SiO/sub 2/ and Si/sub 3/N/sub 4/ waveguides for integrated optics"**

**Description**

## DOMAINE TECHNIQUE

La présente invention concerne un procédé et un appareil de dépôt chimique en phase vapeur, assisté par plasma micro-ondes ("*microwave plasma-enhanced chemical vapour deposition "*), d'une couche mince de silice pour guide d'ondes optiques intégré, utilisant des chlorures.

La présente invention s'applique donc à la fabrication de guides d'ondes optiques intégrés, fabrication au cours de laquelle il faut déposer des couches minces de silice pure ou dopée sur un substrat.

De tels guides d'ondes optiques interviennent dans la fabrication de composants optiques intégrés et de composants optiques hybrides.

De tels composants sont eux-mêmes utilisables dans le domaine des télécommunications optiques.

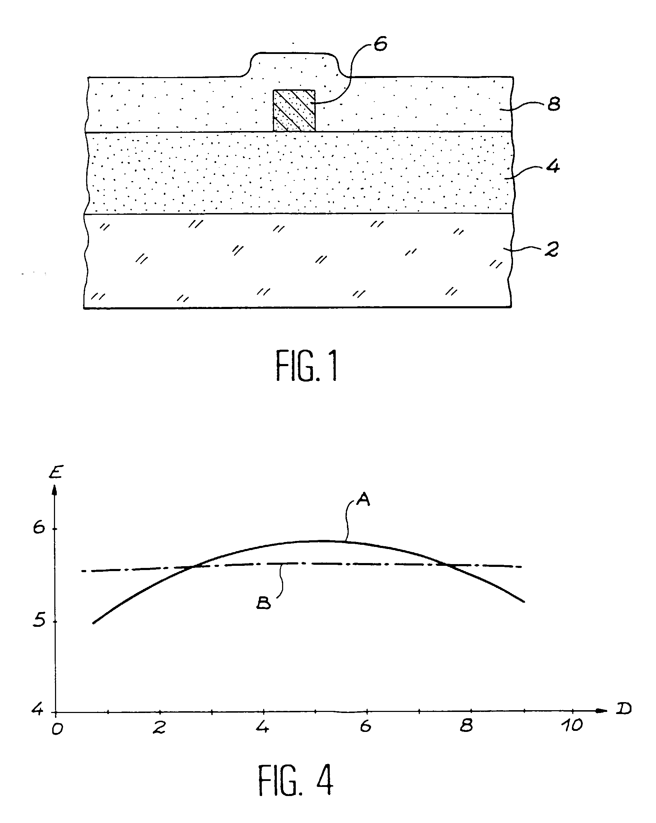

La figure 1 est une vue en coupe schématique d'un exemple de guide d'ondes optiques intégré connu.

Le guide d'ondes optiques de la figure 1 comprend un substrat 2 sur lequel est formée une mince couche tampon ou couche d'isolement 4.

Sur cette couche 4 se trouve le coeur 6 du guide d'ondes et ce coeur 6 est recouvert par une mince couche de recouvrement 8.

A titre purement indicatif et nullement limitatif, le substrat 2 est en silice ou en verre, la couche tampon 4 est en silice et a une épaisseur de l'ordre de 10 à 15 $\mu$m, la couche de recouvrement 8 est en silice et a une épaisseur de l'ordre de 10 $\mu$m et le coeur 6 est en silice dopée par $GeO_2$ et a, en coupe transversale, la forme d'un carré de 5 $\mu$m de côté, la différence entre l'indice optique du coeur et l'indice optique de la couche de recouvrement étant de l'ordre de $7 \times 10^{-3}$.

Il est à noter que l'utilisation de tels guides d'ondes optiques pour des composants optiques intégrés destinés aux télécommunications optiques nécessite de faibles atténuations linéiques dans les fenêtres d'utilisation (1,3 $\mu$m et 1,55 $\mu$m).

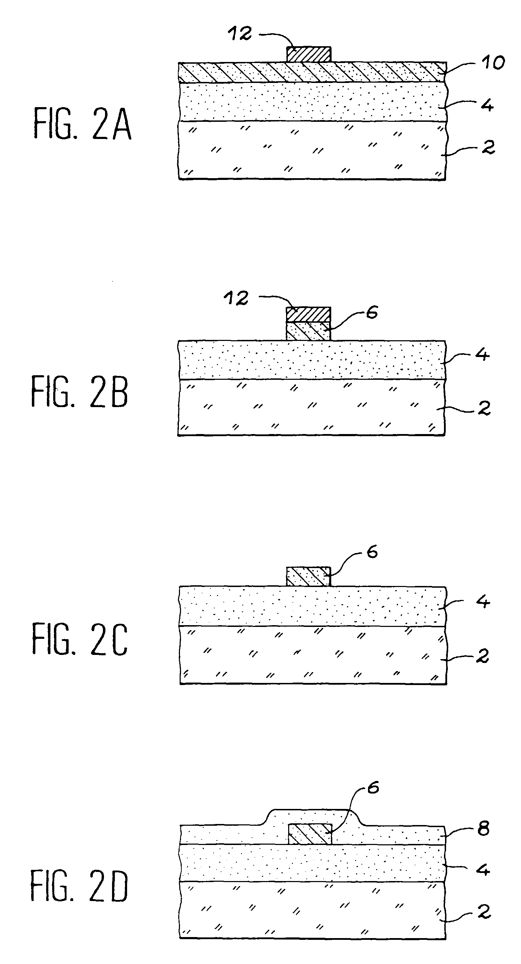

Les figures 2A à 2D illustrent schématiquement des étapes d'un procédé connu de fabrication d'un guide d'ondes optiques du genre de celui de la figure 1.

On commence par déposer la couche 4 sur le substrat 2 puis on forme une mince couche de coeur 10 sur cette couche 4, la couche de coeur étant faite du matériau constitutif du coeur 6 de la figure 1 (figure 2A).

On forme ensuite sur cette couche de coeur 10 un masque 12 servant à la définition du coeur du guide d'ondes optiques par photolithographie.

On forme ensuite le coeur 6 du guide d'ondes par gravure ionique réactive de la couche de coeur 10 (figure 2B).

On élimine ensuite le masque 12 ayant servi à cette gravure (figure 2C).

Ensuite, on dépose la couche de recouvrement 8 sur la couche 4 de manière à recouvrir le coeur 6 (figure 2D).

La fabrication d'un tel guide d'ondes optiques nécessite donc plusieurs étapes de dépôt pour la formation de la couche d'isolement, de la couche de coeur et de la couche de recouvrement.

La qualité de ces couches ainsi que leur homogénéité opto-géométrique (c'est-à-dire l'homogénéité de leur indice de réfraction et l'homogénéité de leur épaisseur) est déterminante pour la qualité finale du guide d'ondes optiques, notamment pour des applications aux télécommunications optiques.

Par ailleurs, d'un point de vue industriel, il est avantageux de disposer d'un procédé de dépôt de couches minces de silice pure ou dopée qui soit rapide et simple à mettre en oeuvre.

## ÉTAT DE LA TECHNIQUE ANTÉRIEURE

On connaît déjà divers procédés de dépôt chimique en phase vapeur (" *chemical vapour* deposition ") de couches minces de silice.

Certains de ces procédés nécessitent une étape de traitement à haute température tandis que d'autres conduisent à de faibles vitesses de dépôt et à des caractéristiques opto-géométriques qui sont peu compatibles avec la fabrication de guides d'ondes optiques.

On connaît notamment par le document (1) qui, comme les autres documents cités par la suite, est mentionné à la fin de la présente description, un procédé à haute température utilisant la technique de dépôt par hydrolyse à la flamme (" *flame hydrolysis deposition "*).

Cette technique est dérivée d'une technique utilisée pour la fabrication de fibres optiques et a pour avantage de conduire à une bonne qualité de silice et à une bonne homogénéité d'indice optique et d'épaisseur.

Cependant l'étape de dépôt doit être suivie d'une étape de consolidation à environ 1300°C pour vitrifier la silice.

On connaît également des procédés de dépôt chimique en phase vapeur par plasma (" *plasma chemical vapour* deposition ") ainsi que des procédés de dépôt chimique en phase vapeur à basse pression (" *low pressure chemical vapour* deposition ") qui nécessitent une étape de recuit à environ 1000°C pour éliminer l'hydrogène présent dans la silice et améliorer la propagation de la lumière à 1,55 $\mu$m.

La vitesse de dépôt est, avec de tels procédés, de l'ordre de 40 nm/mn.

On consultera à ce sujet les documents (2), (3) et (4).

On connaît également des procédés à basse température comme par exemple un procédé utilisant la résonance cyclotronique électronique et un plasma micro-ondes.

Ce procédé permet seulement d'obtenir des vitesses de dépôt de l'ordre de 2,5 nm/mn, ce qui le rend inutilisable pour l'élaboration de couches dont l'épaisseur est de l'ordre de quelques dizaines de μm.

Au sujet de ce procédé connu, on consultera le document (5).

On connaît également un procédé utilisant un réacteur de type Hélicon mais avec ce procédé l'uniformité d'épaisseur n'est pas bonne (elle est de l'ordre de ± 20%) et un recuit à 800°C est nécessaire pour éliminer l'hydrogène contenu dans la silice.

A ce sujet on consultera le document (6).

On connaît aussi un procédé de dépôt chimique en phase vapeur assisté par plasma (" *plasma enhanced chemical vapour deposition ")*, à partir de chlorures.

On consultera à ce sujet le document (7).

Cependant, il est à noter qu'il s'agit d'un plasma radiofréquence et que le dépôt obtenu est poreux et présente une inhomogénéité d'indice optique pour des vitesses de dépôt supérieures à environ 10 nm/mn.

On connaît également par le document (8) intégré par référence à la présente description, un procédé de dépôt chimique en phase vapeur assisté par plasma micro-ondes.

Ce procédé utilise des chlorures et une température moyennement élevée de 800°C.

Il conduit à une vitesse de dépôt élevée (de l'ordre de 200 nm/mn) et nécessite moins d'étapes que certains des procédés mentionnés précédemment car, dans ce procédé connu par le document (8), la silice est directement vitrifiée.

Cependant, ce procédé connu par le document (8) présente l'inconvénient de conduire à une homogénéité d'épaisseur et à une homogénéité d'indice optique (respectivement de l'ordre de ± 2,5% et de l'ordre de ± 0,5x10$^{-3}$ sur 5 cm) qui sont insuffisantes pour la fabrication de guides d'ondes optiques utilisables pour les télécommunications optiques.

## EXPOSÉ DE L'INVENTION

La présente invention a pour but de remédier à ces inconvénients en proposant un procédé de dépôt chimique en phase vapeur, assisté par un plasma micro-ondes, d'une couche mince de silice pour guide d'onde optique intégré, ce procédé conduisant à une meilleure homogénéité d'épaisseur et à une meilleure homogénéité d'indice optique que celles auxquelles conduit le procédé connu par le document (8), tout en conservant les avantages de ce procédé connu (grande vitesse de dépôt et nombre réduit d'étapes) et en étant un procédé à basse température (température inférieure à 800°C).

Le procédé objet de l'invention conduit à une atténuation optique acceptable à 1,55 μm, sans étape supplémentaire de recuit, contrairement aux procédés connus par les documents (2) à (4).

IEICE TRANSACTIONS ON ELECTRONICS, Sept 1992, vol.E75-0, n°9, FUYUKI T. et al. décrit un procédé de dépôt de SiO$_2$ qui utilise une technique de dépôt chimique en phase vapeur par plasma et qui utilise SiH$_4$ pour l'obtention du dioxyde de silicium.

IEEE PROCEEDINGS J (OPTOELECTRONICS) vol.133, n°4, p.264 a 266 décrit un procédé de dépôt chimique en phase vapeur d'une couche mince de silice sur un substrat.

De façon précise, la présente invention a pour objet un procédé de dépôt chimique en phase vapeur sur un substrat, d'une couche mince de silice pour guide d'ondes optiques intégré, à partir d'oxygène et de tétrachlorure de silicium, ce dépôt étant assisté par un plasma créé et entretenu, dans une enceinte contenant le substrat, à l'aide de micro-ondes, ce procédé étant caractérisé en ce que la température du substrat est maintenue à une valeur supérieure ou égale à 200°C et inférieure à 800°C, en ce que la pression dans l'enceinte est maintenue à une valeur de l'intervalle allant de 1 Pa à 20 Pa et en ce qu'un gaz réactif contenant le tétrachlorure de silicium est injecté dans l'enceinte, entre le plasma et le substrat.

Le plasma peut être engendré au moyen d'oxygène.

Le gaz réactif peut contenir en outre de l'oxygène qui sert de gaz de transport du tétrachlorure de silicium.

Le gaz réactif peut en outre contenir au moins un élément permettant de doper la silice.

Le gaz réactif peut contenir, en plus du tétrachlorure de silicium, l'un au moins des composés GeCl$_4$, C$_2$F$_6$, POCl$_3$ et BCl$_3$.

Ceci permet de doper la silice par Ge et/ou F et/ou P et/ou B.

La présente invention est une amélioration du procédé connu par le document (8) pour déposer des couches minces de silice pure ou de silice dopée (dopée essentiellement par Ge ou plus exactement par GeO$_2$), en utilisant un activation des réactions chimiques de dépôt par un plasma micro-ondes (qui est très différent d'un plasma radiofréquence).

Le perfectionnement apporté par la présente invention permet d'obtenir une bonne homogénéité opto-géométrique d'une couche mince ainsi formée (homogénéité d'indice et homogénéité d'épaisseur) sur toute la surface du substrat qui reçoit la couche mince, tout en conservant les avantages procurés par l'emploi d'un plasma micro-ondes combinés à ceux résultant de l'emploi de réactifs sous la forme de chlorures, à savoir :

- procédé à température inférieure à 1000°C,
- procédé simple, le dépôt étant obtenu directement sous forme vitreuse et ne nécessitant donc aucune étape supplémentaire de vitrification à haute température ou de recuit pour abaisser l'atténuation optique à 1,55 μm et à 1,33 μm et,
- vitesse de dépôt élevée.

Avec le procédé objet de la présente invention, on peut utiliser une température du substrat de l'ordre de 500°C à 600°C et on est capable de former des couches de silice dopée par $GeO_2$ qui sont directement vitrifiées à cette température sur des substrats de silicium de l'ordre de 10 cm de diamètre, avec une vitesse de dépôt supérieure à 0,2 μm/mn, avec une bonne homogénéité d'indice optique (0,03% ou moins) et avec une bonne homogénéité d'épaisseur (1,5% ou moins, par exemple 1%).

Des guides d'ondes optiques à ruban (" *stripe optical wave* guides "), qui ont été fabriqués à partir de couches minces de silice formées conformément à la présente invention, présentent des atténuations optiques de l'ordre de 0,2 dB/cm à 1,55 μm et à 1,3 μm.

La présente invention concerne également un appareil de dépôt chimique en phase vapeur sur un substrat, d'une couche mince de silice pour guide d'ondes optiques intégré, à partir d'oxygène et de tétrachlorure de silicium, ce dépôt étant assisté par un plasma, cet appareil comprenant :

- une enceinte,
- un porte-substrat placé dans cette enceinte,
- des moyens de chauffage destinés à maintenir la température du substrat à une valeur déterminée,
- des moyens de pompage destinés à maintenir la pression dans l'enceinte à une valeur déterminée,
- des moyens de création et d'entretien d'un plasma micro-ondes dans une zone de l'enceinte,
- des premiers moyens d'injection prévus pour injecter un gaz plasmagène dans l'enceinte,
- des deuxièmes moyens d'injection prévus pour injecter un gaz réactif contenant le tétrachlorure de silicium dans l'enceinte,

cet appareil étant caractérisé en ce que les moyens de chauffage sont aptes à maintenir la température du substrat à une valeur supérieure ou égale à 200°C et inférieure à 800°C, en ce que les moyens de pompage sont aptes à maintenir la pression dans l'enceinte à une valeur de l'intervalle allant de 1 Pa à 20 Pa et en ce que les deuxièmes moyens d'injection comprennent un injecteur placé en regard du porte-substrat, entre ladite zone et ce porte-substrat.

Selon un mode de réalisation particulier de l'appareil objet de l'invention, l'injecteur a la forme d'un anneau et comprend des perforations en regard du porte-substrat.

La présente invention concerne aussi un procédé de fabrication d'un guide d'ondes optiques intégré, procédé selon lequel on dépose une couche tampon en silice sur un substrat, on dépose une couche de coeur en silice sur cette couche tampon, on forme le coeur du guide à partir de cette couche de coeur et on recouvre le coeur ainsi formé d'une couche de recouvrement en silice, ce procédé étant caractérisé en ce que la couche tampon, la couche de coeur et la couche de recouvrement sont déposées par le procédé de dépôt qui fait également l'objet de l'invention.

## BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :

- la figure 1 est une vue en coupe schématique d'un guide d'ondes optiques connu et a déjà été décrite,
- les figures 2A à 2D illustrent schématiquement des étapes d'un procédé connu de fabrication d'un guide du genre de celui de la figure 1 et ont déjà été décrites,
- la figure 3 est une vue schématique d'un appareil permettant la mise en oeuvre d'un procédé conforme à la présente invention, et
- la figure 4 montre des courbes permettant de faire une comparaison de régularité d'épaisseur entre le procédé connu par le document (8) et un procédé conforme à la présente invention.

## EXPOSÉ DÉTAILLÉ DE MODES DE RÉALISATION PARTICULIERS

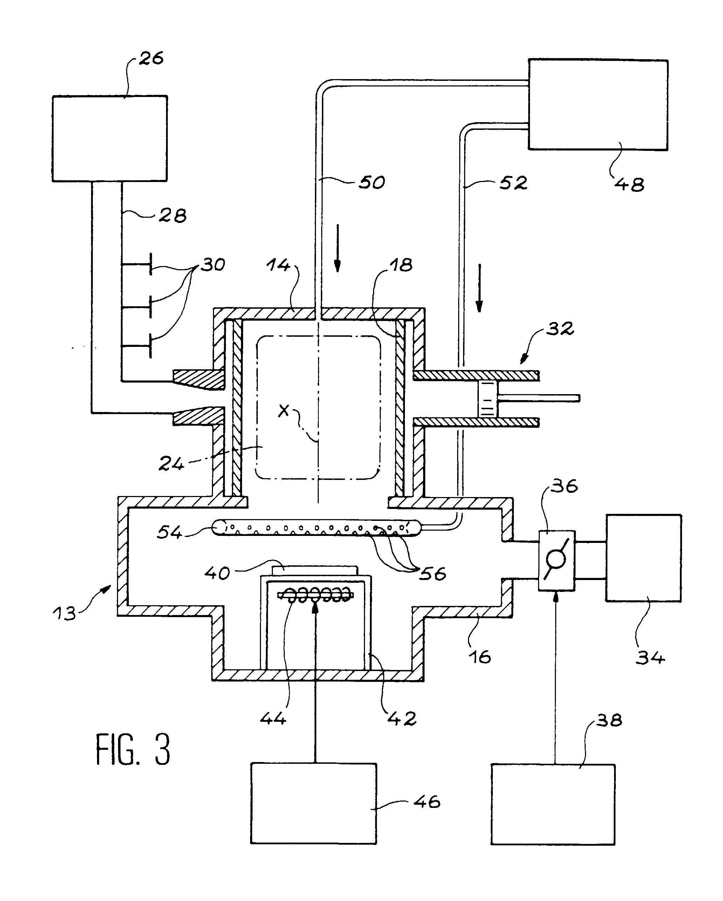

L'appareil de dépôt de couches minces conformément à la présente invention, qui est schématiquement représenté sur la figure 3, comprend une enceinte étanche 13 comprenant une cavité micro-ondes 14, par exemple en aluminium, et une chambre de dépôt 16 qui communique avec la partie inférieure de la cavité micro-ondes 14, comme on le voit sur la figure 3.

L'appareil comprend également un tube en quartz 18 placé à l'intérieur de la cavité 14 et reposant sur un épaulement périphérique 20 situé à la base de cette cavité, le tube 18 communiquant avec la chambre 16 comme on le voit sur la figure 3.

C'est dans ce tube en quartz 18 que l'on crée et l'on entretient le plasma.

La cavité 14, la chambre 16 et le tube 18 présentent une symétrie de révolution autour d'un axe commun X.

On a délimité par un trait mixte la zone dans laquelle se trouve le plasma 24.

On voit également sur la figure 3 un générateur de micro-ondes 26 qui alimente en micro-ondes la cavité 14 par l'intermédiaire d'un guide d'ondes 28.

On voit également des vis d'accord 30 dont est muni le guide d'ondes 28.

L'appareil comprend également un court-circuit à piston 32 monté sur la cavité micro-ondes 14 en regard de l'endroit où le guide d'ondes 28 communique avec cette cavité 14.

Un groupe de pompage 34 permet de faire le vide dans la cavité 14 et la chambre 16.

Ce groupe de pompage 34 est prévu pour que la pression dans l'enceinte atteigne une valeur choisie dans l'intervalle allant d'environ 1 Pa à environ 20 Pa.

Ce groupe de pompage communique avec la chambre de dépôt 16 par l'intermédiaire d'une vanne 36.

Cette vanne 36 est commandée par des moyens de régulation de pression 38 permettant de maintenir la pression à la valeur choisie.

On voit également sur la figure 3 un substrat 40, par exemple en silicium, sur lequel on veut former une couche mince de silice pure ou dopée.

Ce substrat repose sur un porte-substrat 42 placé dans la chambre de dépôt en regard du tube de quartz 18 et de façon coaxiale à ce dernier.

Le porte-substrat 42 est muni de moyens de chauffage 44 destinés à porter le substrat 40 à une température supérieure ou égale à 200°C mais ne dépassant pas 800°C.

Ces moyens de chauffage 44 sont commandés par un système de régulation de température 46 permettant de maintenir la température du substrat 40 à la valeur choisie, par exemple 600°C.

L'appareil conforme à l'invention schématiquement représenté sur la figure 3 comprend aussi un système d'alimentation en gaz 48.

Ce système 48 est destiné à envoyer un gaz plasmagène dans la cavité micro-ondes 14 par l'intermédiaire d'un tube 50 qui débouche à la partie supérieure de la cavité 14 suivant l'axe X de celle-ci.

Ce gaz plasmagène peut être de l'oxygène seul ou de l'argon contenant de l'oxygène, l'oxygène étant en quantité suffisante pour pouvoir former, en coopération avec un gaz réactif approprié, une couche de silice sur le substrat 40.

Le système d'alimentation en gaz 48 est également prévu pour amener ce gaz réactif dans l'enceinte.

Le gaz réactif est transporté dans un conduit 52 qui traverse une paroi de la chambre de dépôt 16 par un passage étanche non représenté et dont l'extrémité située dans cette chambre de dépôt 16 se raccorde de façon étanche à un distributeur ou injecteur de gaz réactif 54.

Ce distributeur de gaz réactif est en forme d'anneau d'axe X et placé entre le porte-substrat 42 et la partie inférieure de la cavité micro-ondes 14 comme on le voit sur la figure 3.

Ainsi, ce distributeur annulaire 54 se trouve entre la base du plasma 24 et le substrat 40, près de ce substrat 40.

L'injecteur 54 est pourvu d'un grand nombre de perçages 56 qui se trouvent en regard du porte-substrat 42 et par lesquels sort le gaz réactif.

Pour former une couche de silice pure, on utilise du tétrachlorure de silicium en tant que réactif.

Si l'on veut former une couche de silice par exemple dopée par $GeO_2$, on utilise en tant que réactif un mélange de tétrachlorure de silicium et de tétrachlorure de germanium.

Le gaz réactif est obtenu en prélevant $SiCl_4$ (et éventuellement $GeCl_4$ ou, plus généralement, tout autre chlorure servant au dopage) par " bullage " au moyen d'un courant d'oxygène, l'oxygène constituant ainsi un gaz de transport (et faisant ainsi partie du gaz réactif).

Dans l'enceinte de l'appareil, la pression, dont la valeur appartient à l'intervalle allant de 1 Pa à 20 Pa, est inférieure à celle qui est utilisée pour la mise en oeuvre du procédé décrit dans le document (8).

Ceci permet notamment d'abaisser la température à laquelle on forme la couche mince de silice dans une zone plus favorable à l'obtention d'un bon rendement d'incorporation d'un dopant comme par exemple $GeO_2$.

Dans le procédé conforme à l'invention, l'injection du gaz réactif diffère également de l'injection dont il est question dans le document (8).

Ceci permet de s'affranchir des inhomogénéités liées au plasma et/ou à l'hydrodynamique de l'appareil (qui est un réacteur à plasma).

Considérons d'abord l'abaissement de la température de dépôt.

L'indice de réfraction d'une couche de silice dopée est lié à la concentration en dopant.

L'incorporation du ou des dopants, par exemple $GeO_2$, dépend de la température du substrat sur lequel on forme la couche.

En effet, une partie de $GeO_2$ est évaporée selon la réaction suivante :

$$GeO_2(solide) \rightarrow GeO(gaz) + \tfrac{1}{2} O_2 \ (gaz).$$

L'homogénéité d'indice optique sur la surface du substrat dépend donc de l'uniformité de la température de surface.

De même, l'homogénéité d'indice optique dans l'épaisseur du substrat dépend de la régularité de la température au cours du temps.

La variation relative $\delta n/\delta T$ (où n représente l'indice optique et T la température) dépend donc de la température pour des conditions expérimentales données.

D'après les lois de la thermodynamique, cette variation relative est plus faible à basse température.

Ceci est confirmé par l'expérience.

En mesurant la valeur de l'indice optique en fonction du taux $GeCl_4/SiCl_4$ pour une pression donnée (par exemple 3 Pa) et à différentes températures (par exemple 600°C et 800°C) et en utilisant les données contenues dans le document (9) auquel on se reportera, on peut déduire la concentration correspondante en $GeO_2$ dans le dépôt de silice et, par conséquent, le rendement d'incorporation du dopant.

Ainsi, à 800°C, ce rendement est de l'ordre de 50% et quasiment de 100% à 600°C.

On peut ainsi considérer que les variations d'indice optique induites par une variation de température deviennent négligeables à 600°C.

Une expérience menée à 500°C a montré que l'indice optique est identique à celui obtenu à 600°C, ce qui est bien en accord avec un taux d'incorporation de 100%.

Cependant, un dépôt effectué à 600°C dans les mêmes conditions de pression présente une structure moins dense qu'à 800°C.

Cela est mis en évidence par la vitesse de gravure chimique dans une solution de type P-etch.

Cette vitesse de gravure est plus élevée pour un dépôt réalisé à 600°C que pour un dépôt réalisé à 800°C, que la silice soit pure ou dopée, ce qui révèle une densité plus faible.

Un abaissement de la pression permet d'obtenir une densité normale c'est-à-dire proche de celle de la silice thermique qui est prise comme référence.

Ainsi, par exemple, il suffit d'abaisser la pression de 3 Pa à 2 Pa (à 600°C) pour diminuer la vitesse de gravure de 0,1 nm/s et retrouver la même vitesse de gravure chimique et donc la même densité qu'à 800°C, c'est-à-dire la densité de la silice thermique prise pour référence.

On considère maintenant l'injection du gaz réactif.

Comme on l'a vu plus haut, celui-ci et le gaz plasmagène sont introduits de façon séparée dans le réacteur à plasma de la figure 3.

Le gaz plasmagène, par exemple l'oxygène, est introduit dans la partie amont du réacteur et permet (par exemple sous l'action d'une onde de surface) d'entretenir le plasma.

Le réactif tel que $SiCl_4$, éventuellement additionné de $GeCl_4$ et/ou de $C_2F_6$ et/ou de $POCl_3$ et/ou de $BCl_3$ suivant le dopage voulu, est introduit, avec l'oxygène de transport, à la base du plasma, dans la partie avale du réacteur, près du substrat.

Les espèces réactives résultant du gaz plasmagène parviennent, par diffusion du plasma, à la zone de dépôt où elles provoquent des réactions chimiques en volume qui conduisent aux réactions surfaciques de dépôt conduisant elles-mêmes à la croissance d'une couche directement vitrifiée.

L'injection des réactifs à la base du plasma, plutôt qu'en amont de celui-ci comme dans le document (8), permet de s'affranchir en grande partie des inhomogénéités dues au plasma (répartition des espèces actives dans le plasma) et à l'écoulement du flux gazeux dans le réacteur.

Ceci est schématiquement illustré par la figure 4 qui permet de comparer la régularité de l'épaisseur E d'une couche (exprimée en unités arbitraires) sur un substrat de diamètre D (exprimé en cm), entre le cas (courbe expérimentale A) où l'injecteur de gaz réactif est placé dans la partie amont du réacteur, comme dans le cas du document (8), et le cas (courbe expérimentale B) où cet injecteur se trouve dans la partie avale du réacteur conformément à la présente invention.

On voit nettement sur la figure 4 que l'homogénéité d'épaisseur est meilleure lorsque l'injecteur se trouve en post-décharge (courbe B) que lorsque l'injecteur se trouve dans la décharge (courbe A).

Pour la mise en oeuvre du procédé conforme à la présente invention, on peut également utiliser un réacteur à plasma du genre de celui qui est décrit dans le document (10) auquel on se reportera, en adaptant ce réacteur, c'est-à-dire en prévoyant un distributeur de gaz réactif à la base du plasma, près du support de substrat.

Pour fabriquer un guide d'ondes optiques intégré, conformément à l'invention, on utilise par exemple le procédé décrit en faisant référence aux figures 2A à 2D, étant entendu que chacune des couches minces de silice, référencées 4, 8 et 10, sont alors formées comme on l'a expliqué précédemment (maintien du substrat sur lequel on dépose la couche à une température t, $200°C{\leq}t{<}800°C$, maintien de la pression dans l'enceinte de dépôt à une valeur p, $1\,Pa{\leq}p{\leq}20\,Pa$, injection du gaz réactif contenant $SiCl_4$ dans l'enceinte, entre le plasma et ce substrat).

Dans le réacteur de la figure 3, la pression est comprise entre 1 Pa et 20 Pa pour un débit total pouvant aller jusqu'à 200 $cm^3$ standards par minute (200 sccm).

La puissance micro-ondes peut être comprise entre 500 W et 3000 W et la température ne dépasse pas 800°C et vaut par exemple 600°C.

Des guides d'ondes optiques intégrés ont été réalisés à partir de ces conditions expérimentales.

Chacun d'entre eux est formé à partir d'une couche d'isolement de 11 μm d'épaisseur en silice dopée à 2% de $GeO_2$, d'une couche de coeur de 8 μm d'épaisseur en silice dopée à 8% de $GeO_2$ et d'une couche de recouvrement de 6 μm d'épaisseur en silice dopée à 2% de $GeO_2$.

Les deux premières couches sont déposées en une seule étape d'une durée de 80 minutes.

Un guide à ruban (" *stripe* guide ") est ensuite obtenu par gravure ionique réactive dans un plasma formé à partir de $CHF_3/C_2F_6$ avant de procéder au dépôt de la couche de recouvrement.

Aucun recuit n'est effectué.

Les guides obtenus ont une section de 8x8 $μm^2$ pour une différence d'indice optique qui vaut $6x10^{-3}$.

Ils présentent une atténuation de 0,2 dB/cm à 1,55 μm, ce qui montre que leur teneur en impuretés hydrogénées ou azotées est suffisamment faible pour qu'ils soient utilisables dans le domaine des télécommunications optiques.

Les documents cités dans la présente description sont les suivants :

(1) M. KAWACHI et al., Optical and Quantum Electronics, vol.22, 1990, p.391 à 416

(2) G. GRAND et al., Electronics Letters, vol.6, n°25, 6 décembre 1990, p.2135 à 2137

(3) F. BRUNO et al., Applied Optics, vol.30, n°31, 1er novembre 1991, p.4560 à 4564

(4) C.H. HENRY et al., Applied Optics, vol.26, n°13, 1er juillet 1987, p.2621 à 2624

(5) T.T. CHAU et al., J. Vac. Sci. Technol. B 10(5), Sep/Oct 1992, p.2170 à 2178

(6) G. GIROULT-MATLAKOWSKI et al., J. Vac. Sci. Technol. A12(5), Sep/Oct 1994, p.2754 à 2761

(7) A. ORTIZ et al., J. Electronic Materials, vol.19, n°12, 1990, p.1411 à 1415

(8) H. MOISAN, M. MOISAN, P. BURLET, D. PAVY, F. LE DAMANY, M. VALETTE, S. SAADA, Proceedings of the 9th C.I.P., Antibes (France), 1993

(9) C.R. HAMMOND et al., Optical and Quantum Electronics, 9(1977), p.399 à 409

(10) EP-A-0 398 832 (DEFITECH S.A.)

## Revendications

1. Procédé de dépôt chimique en phase vapeur sur un substrat (40), d'une couche mince de silice pour guide d'ondes optiques intégré, à partir d'oxygène et de tétrachlorure de silicium, ce dépôt étant assisté par un plasma (24) créé et entretenu, dans une enceinte (13) contenant le substrat, à l'aide de micro-ondes, ce procédé étant caractérisé en ce que la température du substrat est maintenue à une valeur supérieure ou égale à 200°C et inférieure à 800°C, en ce que la pression dans l'enceinte est maintenue à une valeur de l'intervalle allant de 1 Pa à 20 Pa et en ce qu'un gaz réactif contenant le tétrachlorure de silicium est injecté dans l'enceinte, entre le plasma et le substrat.

2. Procédé selon la revendication 1, caractérisé en ce que le plasma (24) est engendré au moyen d'oxygène.

3. Procédé selon l'une quelconque des revendications 1 et 2, caractérisé en ce que le gaz réactif contient en outre de l'oxygène qui sert de gaz de transport du tétrachlorure de silicium.

4. Procédé selon l'une quelconque des revendications 1 à 3, caractérisé en ce que le gaz réactif contient en outre au moins un élément permettant de doper la silice.

5. Procédé selon l'une quelconque des revendications 1 à 3, caractérisé en ce que le gaz réactif contient en outre l'un au moins des composés $GeCl_4$, $C_2F_6$, $POCl_3$ et $BCl_3$.

6. Procédé selon l'une quelconque des revendications 1 à 5, caractérisé en ce que la température du substrat est maintenue à une valeur de l'ordre de 500°C à 600°C.

7. Appareil de dépôt chimique en phase vapeur sur un substrat (40), d'une couche mince de silice pour guide d'ondes optiques intégré, à partir d'oxygène et de tétrachlorure de silicium, ce dépôt étant assisté par un plasma (24), cet appareil comprenant :

   • une enceinte (13),
   • un porte-substrat (42) placé dans cette enceinte,
   • des moyens de chauffage (44, 46) destinés à maintenir la température du substrat à une valeur déterminée,
   • des moyens de pompage (34, 36, 38) destinés à maintenir la pression dans l'enceinte à une valeur déterminée,
   • des moyens (26, 28) de création et d'entretien d'un plasma micro-ondes (24) dans une zone de l'enceinte,
   • des premiers moyens d'injection (50) prévus pour injecter un gaz plasmagène dans l'enceinte,
   • des deuxièmes moyens d'injection (52, 54) prévus pour injecter un gaz réactif contenant le tétrachlorure de silicium dans l'enceinte,

   cet appareil étant caractérisé en ce que les moyens de chauffage sont aptes à maintenir la température du substrat à une valeur supérieure ou égale à 200°C et inférieure à 800°C, en ce que les moyens de pompage sont aptes à maintenir la pression dans l'enceinte à une valeur de l'intervalle allant de 1 Pa à 20 Pa et en ce que les deuxièmes moyens d'injection comprennent un injecteur (54) placé en regard du porte-substrat, entre ladite zone et ce porte-substrat.

8. Appareil selon la revendication 7, caractérisé en ce que l'injecteur (54) a la forme d'un anneau et comprend des perforations (56) en regard du porte-substrat.

9. Procédé de fabrication d'un guide d'ondes optiques intégré, procédé selon lequel on dépose une couche tampon en silice sur un substrat, on dépose une couche de coeur en silice sur cette couche tampon, on forme le coeur du guide à partir de cette couche de coeur et on recouvre le coeur ainsi formé d'une couche de recouvrement en silice, ce procédé étant caractérisé en ce que la couche tampon, la couche de coeur et la couche de recouvrement sont déposées par le procédé conforme à l'une quelconque des revendications 1 à 6.

**Patentansprüche**

1. Verfahren zur chemischen Gasphasenabscheidung einer Siliciumdioxid-Dünnschicht auf einem Substrat (40) zur Herstellung eines integrierten Lichtwellenleiters aus Sauerstoff und Siliciumtetrachlorid, wobei diese Abscheidung durch ein Plasma (24) unterstützt wird, das in einem Behälter (13), der das Substrat enthält, durch Mikrowellen erzeugt und unterhalten wird,
   **dadurch gekennzeichnet,**
   dass die Temperatur des Substrats auf einem Wert gehalten wird, der höher als oder gleich 200°C und niedriger als 800°C ist, dass der Druck in dem Behälter auf einem Wert gehalten wird, dessen Intervall von 1 Pa bis 20 Pa geht, und dadurch, dass ein das Siliciumtetrachlorid enthaltendes reaktives Gas in den Behälter eingeblasen wird, zwischen dem Plasma und dem Substrat.

2. Verfahren nach Anspruch 1, dadurch gekennzeichnet, dass das Plasma (24) mit Hilfe von Sauerstoff erzeugt wird.

3. Verfahren nach einem der Ansprüche 1 und 2, dadurch gekennzeichnet, dass das reaktive Gas außerdem Sauerstoff enthält, der als Transportgas des Siliciumtetrachlorids dient.

4. Verfahren nach einem der Ansprüche 1 bis 3, dadurch gekennzeichnet, dass das reaktive Gas außerdem wenigstens ein Element enthält, das ermöglicht, das Siliciumdioxid zu dotieren.

5. Verfahren nach einem der Ansprüche 1 bis 3, dadurch gekennzeichnet, dass das reaktive Gas außerdem wenigstens eine der Verbindungen $GeCl_4$, $C_2F_6$, $POCl_3$ und $BCl_3$ enthält.

6. Verfahren nach einem der Ansprüche 1 bis 5, dadurch gekennzeichnet, dass die Temperatur des Substrats auf einem Wert in der Größenordnung von 500°C bis 600°C gehalten wird.

7. Vorrichtung zur chemischen Gasphasenabscheidung einer Siliciumdioxid-Dünnschicht auf einem Substrat (40) zur Herstellung eines integrierten Lichtwellenleiters aus Sauerstoff und Siliciumtetrachlorid, wobei diese Abscheidung durch ein Plasma (24) unterstützt wird und diese Vorrichtug umfasst:

   - einen Behälter (13),
   - einen Substratträger (42) im Innern dieses Behälters,
   - Heizeinrichtungen (44, 46), um die Temperatur des Substrats auf einem festgelegten Wert zu halten,
   - Pumpeinrichtungen (34, 36, 38), um den Druck in dem Behälter auf einem bestimmten Wert zu halten,
   - Einrichtungen (26, 28) zum Erzeugen und Unterhalten eines Mikrowellen-Plasmas (24) in einer Zone des Behälters,
   - erste Einblaseinrichtungen (50), vorgesehen für das Einblasen eines plasmagenen Gases in den Behälter,
   - zweite Einblaseinrichtungen (52, 54), vorgesehen für das Einblasen eines das Siliciumtetrachlorid enthaltenden reaktiven Gases in den Behälter,

   wobei diese Vorrichtung dadurch gekennzeichnet ist, dass die Heizeinrichtungen fähig sind, die Temperatur des Substrats auf einen Wert höher als oder gleich 200°C und niedriger als 800°C zu halten, dass die Pumpeinrichtungen fähig sind, den Druck in dem Behälter auf einem Wert zu halten, dessen Intervall von 1 Pa bis 20 Pa geht, und dadurch, dass die zweiten Einblaseinrichtungen einen Injektor (54) umfassen, der dem Substratträger zwischen der genannten Zone und diesem Substratträger gegenübersteht.

8. Vorrichtung nach Anspruch 7, dadurch gekennzeichnet, dass der Injektor (54) die Form eines Rings hat und Perforationen (56) aufweist, die dem Substratträger gegenüberstehen.

9. Herstellungsverfahren eines integrierten optischen Wellenleiters, wobei man nach diesem Verfahren eine Pufferschicht aus Siliciumdioxid auf einem Substrat abscheidet, man den Kern des Leiters aus dieser Kernschicht bildet und man den so gebildeten Kern mit einer Verkleidungsschicht aus Siliciumdioxid überzieht, wobei dieses Verfahren dadurch gekennzeichnet ist, dass die Pufferschicht, die Kernschicht und die Verkleidungsschicht nach dem mit einem der Ansprüche 1 bis 6 konformen Verfahren abgeschieden werden.

**Claims**

1. Process for the chemical vapour deposition, on a substrate (40), of a thin layer of silica for an integrated optical waveguide, from oxygen and silicon tetrachloride, this deposition being enhanced by a plasma (24) created and maintained, in an enclosure (13) containing the substrate, with the aid of microwaves, this process being characterized in that the temperature of the substrate is maintained at a value greater than or equal to 200°C and less than 800°C, in that the pressure in the enclosure is maintained at a value within the range going from 1 Pa to 20 Pa and in that a reactive gas containing silicon tetrachloride is injected into the enclosure between the plasma and the substrate.

2. Process according to Claim 1, characterized in that the plasma (24) is generated by means of oxygen.

3. Process according to either of Claims 1 and 2, characterized in that the reactive gas furthermore contains oxygen which serves as a carrier gas for the silicon tetrachloride.

4. Process according to any one of Claims 1 to 3, characterized in that the reactive gas furthermore contains at least one element allowing the silica to be doped.

5. Process according to any one of Claims 1 to 3, characterized in that the reactive gas furthermore contains at least one of the compounds $GeCl_4$, $C_2F_6$, $POCl_3$ and $BCl_3$.

6. Process according to any one of Claims 1 to 5, characterized in that the temperature of the substrate is maintained at a value of the order of 500°C to 600°C.

7. Apparatus for the chemical vapour deposition, on a substrate (40), of a thin layer of silicon for an integrated optical waveguide, from oxygen and silicon tetrachloride, this deposition being enhanced by a plasma (24), this apparatus comprising:

   • an enclosure (13),
   • a substrate holder (42) placed in this enclosure,
   • heating means (44, 46) intended to maintain the temperature of the substrate at a predetermined value,
   • pumping means (34, 36, 38) intended to maintain the pressure in the enclosure at a predetermined value,
   • means (26, 28) for creating and for maintaining a microwave plasma (24) in one region of the enclosure,
   • first injection means (50) provided for injecting a plasma gas into the enclosure,
   • second injection means (52, 54) provided for injecting a reactive gas containing silicon tetrachloride into the enclosure,

   this apparatus being characterized in that the heating means are capable of maintaining the temperature of the substrate at a value greater than or equal to 200°C and less than 800°C, in that the pumping means are capable of maintaining the pressure in the enclosure at a value within the range going from 1 Pa to 20 Pa and in that the second injection means comprise an injector (54) placed opposite the substrate holder, between the said region and this substrate holder.

8. Apparatus according to Claim 7, characterized in that the injector (54) has the shape of a ring and comprises perforations (56) opposite the substrate holder.

9. Process for fabricating an integrated optical waveguide, according to which process a silica buffer layer is deposited on a substrate, a silica core layer is deposited on this buffer layer, the core of the guide is formed from this core layer and the core thus formed is covered with a silica covering layer, this process being characterized in that the buffer layer, the core layer and the covering layer are deposited by the process according to any one of Claims 1 to 6.

FIG. 1

FIG. 4

FIG. 2A

FIG. 2B

FIG. 2C

FIG. 2D

FIG. 3